Europäisches Patentamt

(19) European Patent Office

Office européen des brevets

(11) Publication number: 0 244 116
B1

(12) EUROPEAN PATENT SPECIFICATION

(45) Date of publication of patent specification: 12.09.90

(51) Int. Cl.⁵: H 03 H 11/12

(21) Application number: 87303263.5

(22) Date of filing: 14.04.87

(54) Analog circuit improvement in a digital integrated circuit technology.

(30) Priority: 28.04.86 CA 507792

(43) Date of publication of application:
04.11.87 Bulletin 87/45

(45) Publication of the grant of the patent:
12.09.90 Bulletin 90/37

(84) Designated Contracting States:
DE FR GB NL SE

(56) References cited:
EP-A-0 117 008
US-A-3 204 192

IEEE JOURNAL OF SOLID-STATE CIRCUITS, vol.
SC-17, no. 6, December 1982, pages 1076-1080,
IEEE, New York, US; B.K. AHUJA:
"Implementation of active distributed RC anti-
aliasing/smoothing filters"

ELECTRONIQUE APPLICATIONS, no. 15, 1980,
pages 27-28, Paris, FR; M. QUERE: "Filtre
psophométrique"

(73) Proprietor: NORTHERN TELECOM LIMITED
600 de la Gauchetiere Street West
Montreal Quebec H3B 4N7 (CA)

(72) Inventor: Little, Thomas Noble
233 McElroy Drive
Kanata, Ontario, K2L 1Y3 (CA)
Inventor: Longo, Lorenzo Lino
22 Harlowe Crescent
Nepean Ontario K2H 5P1 (CA)
Inventor: Chan, Sun-Shiu David
22 Sulky Way
Kanata, Ontario, K2M 1G6 (CA)

(74) Representative: Crawford, Andrew Birkby et al
A.A. THORNTON & CO. Northumberland House
303-306 High Holborn
London WC1V 7LE (GB)

Courier Press, Leamington Spa, England.

## Description

### Field of the invention

The invention is in the field of analog filter circuits and more particularly relates to a filter circuit within an integrated circuit structure.

### Background of the invention

Production of electronic circuits, in the form of very large scale integrated (VLSI) circuits, has recently become common place. A typical VLSI circuit is usually of the digital circuit type, and of such complexity that may be more appropriately referred to as a system. However, in some circumstances a complete practical system is not attainable in a single VLSI circuit of the digital circuit type, because of a requirement to interface with external analog signals. Such an interface requirement is usually provided by an analog-to-digital conversion circuit or by a digital-to-analog conversion circuit as the case requires. It is usual that some analog circuitry is required for coupling between analog signal ports and the conversion circuitry.

Among various VLSI manufacturing technologies, those well suited for producing digital VLSI circuit elements are not well suited to providing analog circuit elements. For example the operating characteristics of an analog filter circuit are determined by circuit component values such as resistance and reactance. However, in a VLSI digital optimized technology, such as a complementary metal oxide semiconductor (CMOS) technology, the values of resistive and capacitive circuit elements are not nearly as precisely obtainable as with discretely manufactured or selectively trimmed components. Furthermore active analog elements such as differential amplifiers and the like, provided by this technology, have characteristics which are inferior as compared with typical off-the-shelf active analog components.

In spite of these difficulties analog signal circuits have been provided in CMOS technology VLSI circuits, albeit with compromised but tolerable functionality. This has been achieved by a filter design which is optimized to be as insensitive as possible to processing and temperature variation. In this design, distributed rather than lumped capacitive elements are used. The distributed capacitive element is formed along a resistive path of an associated resistive element to provide a resistor capacitor pair configuration. A conductive electrode provides a plate of the capacitor and carries a dielectric layer between it and a polycrystalline silicon layer which is tailored to provide the resistor element. This produces a distributed capacitive effect and reduces stray capacitance effects between the resistor element and the substrate of the VLSI circuit. The product of the R and C values of the pair configuration remains somewhat stable in spite of undesirable process variations. For example if an over etch variation occurs a thinner resistor element is produced having an increased resistance value. At the same time however, the capacitance coupling at the conductive electrode is decreased. Since the pole frequency of the filter is determined by the RC products of the pair configuration, the process variation tends to be of little consequence as compared to a circuit with independent capacitor and resistor elements.

In one example, a simple network of paired resistive and capacitive elements is connected with a differential amplifier to provide a second order low pass filter for analog signals entering a VLSI circuit. Such a filter exhibits all the required low passband filter characteristics except for higher frequencies which are about an octave or more removed from the passband. Signals of such frequencies tend to traverse the analog filter with less than desirable attenuation and tend to have a deleterious effect upon any subsequent analog-to-digital conversion function.

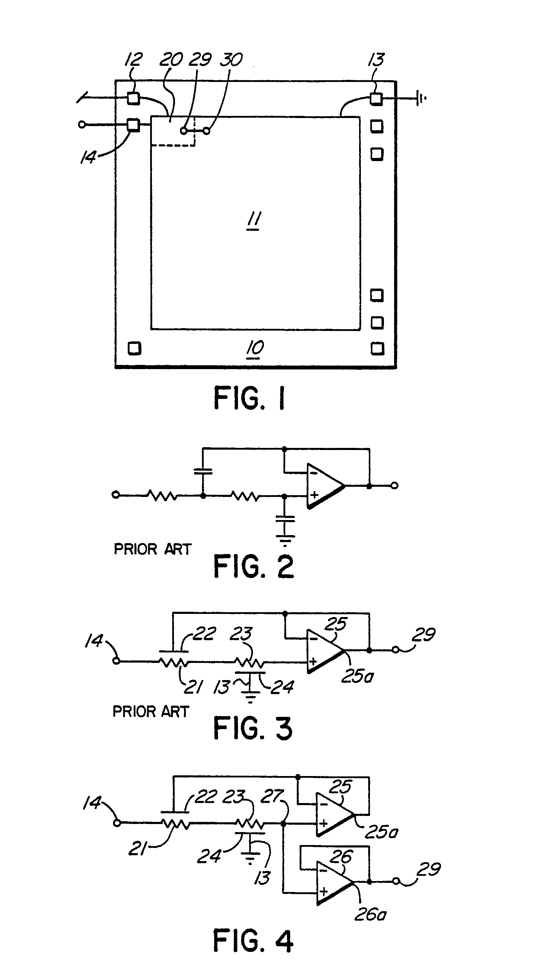

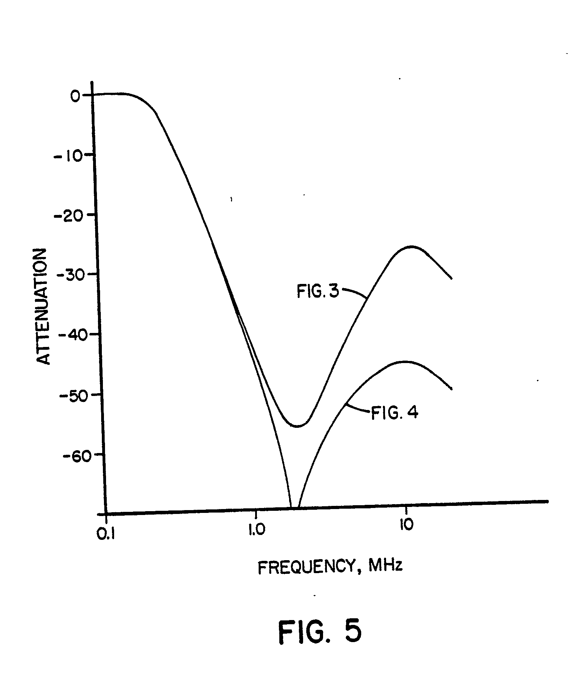

A circuit of this kind is described in IEEE Journal of Solid-State Circuits, vol. SC-17, No. 6, December 1982, pages 1076—1080 under the title "Implementation of active distributed RC anti-aliasing/smoothing filters" and is illustrated, for example, in Figure 3.

### Summary of the invention

It is an object of the invention to achieve an improved analog filter circuit function in a digital integrated circuit, without requiring any additional processing step in the manufacture of the integrated circuit.

The present invention provides a filter, for analog signals, comprising:

a filter input electrode, for receiving an analog signal;

a filter output electrode, for providing a filtered analog signal;

a first amplifier being a differential amplifier and having an output and inverting and non-inverting inputs;

a first resistive capacitive element and a second resistive capacitive element being connected in series between the filter input electrode and the non-inverting input of the first amplifier to provide a resistive path therebetween, a capacitance electrode of the first resistive capacitive element being connected to the output and the inverting input of the first amplifier, the output and the inverting input of the first amplifier being connected together, and a capacitance electrode of the second resistive capacitive element being connected to ground; characterised in that the filter further comprises:

a second amplifier being connected in voltage follower configuration between the non-inverting input of the first amplifier and the filter output electrode, for providing the filtered analog signal at the filter output electrode.

One example of the present invention provides a CMOS integrated circuit comprising an active filter circuit as described above and a digital circuit means, the active filter circuit comprising:

power and ground electrodes for connection across a source of power; and wherein

the output electrode being connected to the digital circuit means;

and the second amplifier is a differential amplifier including an output, an inverting input which is connected to the output electrode and a non-inverting input which is connected to a junction of the second resistive capacitive element and the non-inverting input of the first differential amplifier.

Brief description of the drawings

An example embodiment is described with reference to the accompanying drawings in which:

Figure 1 is a block drawing of an example geography of an integrated circuit chip in which a circuit in accordance with the invention is useful.

Figure 2 is a schematic diagram of a known low pass filter circuit;

Figure 3 is a schematic diagram of the filter circuit in Figure 2 as it is normally adapted for integration in the chip in Figure 1;

Figure 4 is a schematic diagram of a low pass filter circuit similar to Figure 3 but which is improved in accordance with the invention; and

Figure 5 is a graphical illustration of operating characteristics of the filter circuits in the Figures 3 and 4.

Detailed description

Figure 1 shows a typical application of the invention. A carrier 10 supports an integrated circuit chip 11, a portion of which includes an analog circuit 20. The analog circuit 20 includes an output 29 connected to a port 30 of a converter circuit, not shown, in the integrated circuit 11. Power, ground and analog signal connection pads 12, 13 and 14 are supported by the carrier along with other connection pads and provide for connections with the chip 11.

A well known form of a prior art second order low pass filter circuit is illustrated in Figure 2. If the filter circuit in Figure 2 is to be integrated in a circuit structure which is produced by a process optimized for digital circuit functions, a structure similar to that of Figure 2, but altered as represented in Figure 3 is usually used. In Figure 3, resistive and capacitive elements, for example 21, 22 are paired by means of a structure which includes the resistive element being of a finite length and the capacitive element being an electrode lying along the length of the resistor and separated therefrom by a dielectric. This is a well known structure in complementary metal oxide semiconductor (CMOS) technology, and although the actual values of resistor and capacitor elements are not precisely predictable, it is well known that the products of values of resistive capacitive pairs are sufficiently predictable to be practically useful. The low pass filters in Figures 3 and 4 are the same insofar as each includes resistive capacitive paired elements 21, 22 and 23, 24. In each filter, the resistance elements 21 and 23 are connected in series between the analog signal input 14 and a non-inverting input of a CMOS implemented differential amplifier 25. An output 25a of the differential amplifier 25 is connected to an inverting input of the differential amplifier 25 and to an electrode of the capacitive element 22. The electrode of the capacitive element 24 is connected to ground. The filter circuits differ in that in the prior art circuit of Figure 3, the output 29 of the filter circuit is provided from the output 25a of the differential amplifier. This is as would be expected and is similar to the form shown in Figure 2. In the filter circuit in Figure 4 a differential amplifier 26 includes an output 26a which is connected to the filter output 29. The differential amplifier 26 is connected in voltage follower configuration as shown, such that in operation the output 29 provides a low impedance source which follows the analog signal at a junction 27.

Operation of the circuits in both Figures 3 and 4 is essentially indistinguishable through the passband illustrated in Figure 5. However, in the case of Figure 3 at higher frequencies, in a stop band shown in Figure 5, attenuation of the analog signal is insufficient. The insufficient attenuation is believed to be a result of unavoidable capacitive coupling between the input 14 and the output 29 via the capacitive electrode 22. At lower frequencies, the coupling is correspondingly less, and the effective output impedance of the amplifier 25 is low. At higher frequencies the gain of the amplifier is reduced and the impedance at the output of the CMOS implemented amplifier 25 is not as low. Hence, in a stop band range of frequencies the filter input and output are in essence capacitively coupled.

In the case of Figure 4, at higher frequencies, the operation is essentially the same as in the case of Figure 3, except for the fact that the filter output 29 is taken from the output 26a of the differential amplifier 26. Thus in operation at frequencies in the stop band even though the second order filter operation is in essence unavailable, the filter continues to operate substantially as a buffered first order filter. In contrast to the stop band operation of the prior art filter in Figure 3, the filter in Figure 4 therefore provides substantially greater attenuation. In many applications this improved functionality renders the inclusion of analog circuitry within CMOS integrated circuitry a practical and cost effective reality.

Figure 5 illustrates improved attenuation characteristics of the filter of Figure 4 as compared to the filter of Figure 3. In Figure 5, the vertical axis of the graph is scaled in decibels and the horizontal axis represents frequency. In the operation of the improved filter, a transition from second order function to first order function begin around a frequency of 1 MHz. This is a frequency above which the output 25a of the differential amplifier 25 no longer closely follows the signal voltage at the non-inverting input. Thus by buffering the voltage at the non-inverting input by means of the amplifier 26, a ten to twenty decibel improvement in attenuation above 1 MHz was obtained as is shown in Figure 5.

**Claims**

1. A filter, for analog signals, comprising:

a filter input electrode (14), for receiving an analog signal;

a filter output electrode (29), for providing a filtered analog signal;

a first amplifier (25) being a differential amplifier and having an output (25a) and inverting and non-inverting inputs;

a first resistive capacitive element (21, 22) and a second resistive capacitive element (23, 24) being connected in series between the filter input electrode (14) and the non-inverting input of the first amplifier (25) to provide a resistive path therebetween, a capacitance electrode (22) of the first resistive capacitive element being connected to the output and the inverting input of the first amplifier (25), the output and the inverting input of the first amplifier (25) being connected together, and a capacitance electrode (24) of the second resistive capacitive element being connected to ground (13); characterised in that the filter further comprises:

a second amplifier (26) being connected in voltage follower configuration between the non-inverting input of the first amplifier and the filter output electrode, for providing the filtered analog signal at the filter output electrode (29).

2. A CMOS integrated circuit (11) comprising an active filter circuit (20) according to claim 1 and a digital circuit means, the active filter circuit comprising:

power and ground electrodes (12, 13) for connection across a source of power; and wherein

the output electrode (29) being connected (30) to the digital circuit means;

and the second amplifier is a differential amplifier (26) including an output (26a) an inverting input which is connected to the output electrode and a non-inverting input which is connected to a junction (27) of the second resistive capacitive element and the non-inverting input of the first differential amplifier (25).

**Patentansprüche**

1. Filter für Analogsignale, mit:

einer Filtereingangselektrode (14) zum Aufnehmen eines Analogsignals;

einer Filterausgangselektrode (29) zum Schaffen eines gefilterten Analogsignals;

einem ersten Verstärker (25), der ein Differentialverstärker mit einem Ausgang (25a) und invertierenden und nichtinvertierenden Eingängen ist;

einem ersten resistiv-kapazitiven Element (21, 22) und einem zweiten resistiv-kapazitiven Element (23, 24), die zwischen der Filtereingangselektrode (14) und dem nichtinvertierenden Eingang des ersten Verstärkers (25) in Reihe geschaltet sind, um dazwischen einen Widerstandsweg zu schaffen, wobei eine Kapazitätselektrode (22) des ersten resistiv-kapazitiven Elements mit dem Ausgang und dem invertierenden Eingang des ersten Verstärkers (25) verbunden ist, der Ausgang und der invertierende Eingang des ersten Verstärkers (25) miteinander verbunden sind und eine Kapazitätselektrode (24) des zweiten resistiv-kapazitiven Elements mit Masse (13) verbunden ist; dadurch gekennzeichnet, daß das Filter weiter umfaßt:

einen zweiten Verstärker (26), der in Spannungsfolgerkonfiguration zwischen dem nichtinvertierenden Eingang des ersten Verstärkers und der Filterausgangselektrode angeschlossen ist zum Schaffen des gefilterten Analogsignals an der Filterausgangselektrode (29).

2. CMOS-IC (11) mit einer aktiven Filterschaltung (20) nach Anspruch 1 und einem Digitalschaltungsmittel, bei dem die aktive Filterschaltung umfaßt:

Leistungs- und Masseelektroden (12, 13) zum Anschluß an eine Leistungsquelle; und wobei

die Ausgangselektrode (29) mit dem digitalen Schaltmittel verbunden (30) ist;

und der zweite Verstärker ein Differentialverstärker (26) ist mit einem Ausgang (26a), einem mit der Ausgangselektrode verbundenen invertierenden Eingang und einem mit einer Verbindungsstelle (27) des zweiten resistiv-kapazitiven Elements mit dem nichtinvertierenden Eingang des ersten Differentialverstärkers (25) verbundenen nichtinvertierenden Eingang.

**Revendications**

1. Filtre, pour signaux analogiques, comprenant:

— une électrode (14) d'entrée du filtre, afin de recevoir un signal analogique;

— une électrode (29) de sortie du filtre, pour fournir un signal analogique filtré;

— un premier amplificateur (25) qui est un amplificateur différentiel et comporte une sortie (25a) et des entrées d'inversion et de non-inversion;

— un premier élément résistif-capacitif (21, 22) et un second élément résistif-capacitif (23, 24) reliés en série entre l'électrode (14) d'entrée du filtre et l'entrée de non-inversion du premier amplificateur (25) pour fournir entre eux un trajet résistif, une électrode (22) de condensateur pour le premier élément résistif-capacitif étant connectée à la sortie et à l'entrée d'inversion du premier amplificateur (25), la sortie et l'entrée d'inversion du premier amplificateur (25) étant connectées ensemble, et une électrode de condensateur (24) du second élément résistif-capacitif étant connectée à la masse (13), caractérisé en ce que le filtre comprend en outre:

— un second amplificateur (26) connecté dans une configuration de suivi de tension entre l'entrée de non-inversion du premier amplificateur et l'électrode de sortie du filtre, afin de fournir le signal analogique filtré à l'électrode (29) de sortie du filtre.

2. Circuit intégré CMOS (11) comprenant un circuit (20) de filtre actif selon la revendication 1, et un moyen de circuit numérique, le circuit du filtre actif comportant:

— des électrodes d'alimentation et de masse (12, 13) pour connexion aux bornes d'une source d'alimentation; et dans lequel

— l'électrode de sortie (29) est reliée (30) au moyen de circuit numérique;

— et le second amplificateur est un amplificateur différentiel (26) comprenant une sortie (26a), une entrée d'inversion qui est connectée à l'électrode de sortie et une entrée de non inversion qui est reliée à la jonction (27) du second élément résistif-capacitif et de l'entrée de non inversion du premier amplificateur différentiel (25).

FIG. 1

PRIOR ART

FIG. 2

PRIOR ART

FIG. 3

FIG. 4

1

FIG. 5